**Europäisches Patentamt**

**European Patent Office**

**Office européen des brevets**

(19)

(11) Veröffentlichungsnummer : **0 012 955**
**B1**

# EUROPÄISCHE PATENTSCHRIFT

(12)

(45) Veröffentlichungstag der Patentschrift :
05.06.85

(21) Anmeldenummer : 79105178.2

(22) Anmeldetag : 14.12.79

(51) Int. Cl.⁴ : **H 01 L 21/31**

(54) **Ätzmittel zum Ätzen von Siliciumoxiden auf einer Unterlage und Ätzverfahren.**

(30) Priorität : 29.12.78 US 974573

(43) Veröffentlichungstag der Anmeldung :
09.07.80 Patentblatt 80/14

(45) Bekanntmachung des Hinweises auf die Patenterteilung : 05.06.85 Patentblatt 85/23

(84) Benannte Vertragsstaaten :
DE FR GB

(56) Entgegenhaltungen :
FR-A- 2 011 513
FR-A- 2 028 332
US-A- 3 979 241

(73) Patentinhaber : **International Business Machines Corporation**
**Old Orchard Road**
**Armonk, N.Y. 10504 (US)**

(72) Erfinder : **Gajda, Joseph John**
**Forest View**
**Wappingers Falls New York 12590 (US)**

(74) Vertreter : **Kreidler, Eva-Maria, Dr. rer. nat.**
**Schönaicher Strasse 220**
**D-7030 Böblingen (DE)**

**Beschreibung**

Die Erfindung betrifft ein Ätzmittel zum Ätzen von Siliciumoxiden mit einem Gehalt an Fluorwasserstoff und einer alles ungebundene Wasser absorbierenden organischen Verbindung und ein Ätzverfahren. Das erfindungsgemäße Ätzmittel ist zum Ätzen von Siliciumoxiden geeignet, greift aber freigelegtes Silicium, insbesondere N-dotiertes Silicium, das sich unter dem Oxid und einer Metallsilicidschicht befindet, nicht an.

Bei der Herstellung integrierter Schaltkreise ist es üblich, die Oberfläche eines Siliciumkörpers mit einer oder mehreren Schichten, die aus anorganischen isolierenden Materialien wie Siliciumdioxid, Siliciumnitrid und dgl. bestehen, zu passivieren und zu schützen.

Durch diese Schutzschichten werden Öffnungen hergestellt, um dotierte Gebiete in dem Halbleiterkörper herzustellen und leitende Schichten auf der Oberfläche des Körpers anordnen zu können mit einem Kontakt zu den dotierten Gebieten. In den meisten Fällen ist es wesentlich, daß ein selektives Ätzmittel angewendet wird, d. h., daß es eine der Schutzschichten ätzt, ohne das Silicium oder die anderen Schutzschichten wesentlich anzugreifen. Beispielsweise ist verdünnte Fluorwasserstoffsäure, welche mit Ammoniumfluorid gepuffert ist, zum Ätzen von Siliciumdioxid geeignet, weil sie Siliciumnitrid oder Silicium nicht wesentlich angreift. In gleicher Weise ist heiße Phosphorsäure zum Ätzen von Siliciumnitrid geeignet, während Siliciumdioxid, Silicium oder die üblicherweise verwendeten Photoresistschichten von ihr nicht angegriffen werden.

Aus der FR-A-2 011 513 ist ein Ätzmittel zum Ätzen von Siliciumoxiden auf einer Unterlage bekannt, das wasserfrei ist und als Bestandteile Fluorwasserstoffsäure, eine Puffersubstanz und eine organische, Wasser absorbierende Verbindung enthält. Als Puffersubstanz wird Ammoniumfluorid und als Wasser absorbierende Verbindungen werden organische Säuren, Alkohole, Glykol und Glycerin genannt. In einem bevorzugten Ausführungsbeispiel wird als Wasser absorbierende Verbindung Eisessig beschrieben.

Es wurde gefunden, daß Standard-gepufferte verdünnte Flußsäurelösung $N^+$- oder N-dotiertes Silicium während der Halbleiterherstellung angreift. Dies trifft besonders dann zu, wenn die Ätzlösung gleichzeitig auf stark dotiertes Silicium und Platinsilicid einwirkt. Als Ursache hierfür ist wahrscheinlich eine elektrochemische Reaktion zwischen dem Silicium und dem Platinsilicid anzusehen, wobei die Reaktionskette geschlossen wird, wenn der Halbleiter in die Standardgepufferte Flußsäurelösung getaucht wird. Dabei findet ein Auflösen des Siliciums, insbesondere $N^+$-dotierten Siliciums statt.

Als Beispiel wird die Herstellung integrierter TTL (Transistor-Transistor-Logik) Chips betrachtet, in denen Platinsilicid sowohl zur Herstellung von Ohmschen Kontakten wie auch zur Herstellung von Schottky-Kontakten mit hoher Barrierenspannung angewendet wird. Diese Struktur ist eine der bekanntesten integrierten Schaltkreisstrukturen in der Halbleiterindustrie und ihr Herstellungsverfahren ist bekannt. Nachdem das Platinsilicid in den Kontaktbereichen gebildet wurde, wird das überschüssige Platin durch Königswasser als Ätzmittel entfernt. Als einziger Schutz für das Platinsilicid dient eine dünne poröse, etwa 3 nm dicke Siliciumdioxidschicht. Weil das Siliciumdioxid dünn und porös ist, kann das Königswasser auch bestimmte Bereiche des Platinsilicids angreifen und dadurch $N^+$- oder N-dotiertes Silicium in den Kontaktbereichen unter der Platinsilicidschicht freilegen. Dabei treten noch keine wesentlichen Probleme auf. Als nächster Schritt beim Standardherstellungsverfahren folgt die Entfernung der dünnen Siliciumdioxidschicht von dem Platinsilicid unter Verwendung einer Standard-gepufferten Flußsäurelösung. Es wurde gefunden, daß die gepufferte Flußsäurelösung das freiliegende $N^+$- oder N-dotierte Silicium angreift, wahrscheinlich wegen der zuvor beschriebenen elektrochemischen Reaktion zwischen dem Silicium und dem Platinsilicid. Dadurch wird Silicium in einem größeren Ausmaß und bis zu einer größeren Tiefe entfernt.

Es wurde auch gefunden, daß in der Lösung vorhandenes $NH_4F$ dazu neigt, die Lochbildung in der Platinsilicidschicht zu bewirken.

Es wurde ferner gefunden, daß eine Pufferung in jedem Fall nicht notwendig ist.

Der nächste Schritt in dem TTL-Herstellungsverfahren ist die Abscheidung einer Sperrschicht aus Metallen wie Chrom, Molybdän, Titan, Wolfram oder Legierungen derselben, die als Sperrschicht zwischen dem Aluminium, das nachfolgend als Verbindungsmetallurgie abgeschieden wird, und dem darunterliegenden Platinsilicid und Silicium wirken. Alle diese Sperrschichtmetalle haben eine wesentlich niedrigere Spannungscharakteristik in Durchlaßrichtung als PtSi, und jeder direkte Kontakt zwischen dem Sperrschichtmetall und dem N-dotierten Silicium bewirkt eine Verschiebung der Spannungscharakteristik, wodurch der Schaltkreis unbrauchbar wird.

Was $N^+$-dotierte Siliciumkontaktbereiche anbetrifft, ist das Ausmaß der elektrochemischen Auflösung noch stärker als bei N-dotiertem Silicium. Die Auflösung hat zur Ausbildung von tiefreichenden Legierungsspikes geführt, die sich während der nachfolgenden Hochtemperaturbehandlung vollständig durch die Kontaktbereiche erstrecken.

Aufgabe der Erfindung ist die Bereitstellung eines Ätzmittels für Siliciumoxide, das, wie aus dem Stand der Technik bekannt ist, kein ungebundenes Wasser enthält; das insbesondere in Gegenwart von Platinsilicid $N^+$- oder N-dotiertes Silicium nicht angreift und keine Lochbildung in einer Platinsilicidschicht bewirkt.

Die Aufgabe der Erfindung wird gelöst durch ein Ätzmittel der eingangs genannten Art, das dadurch gekennzeichnet ist, daß es kein Ammoniumfluorid zur Pufferung enthält. Gegenstand der Erfindung ist auch ein Ätzverfahren unter Verwendung des erfindungsgemäßen Ätzmittels.

Durch die Anwendung des Ätzmittels können Kurzschlüsse vermieden werden, die, durch die Reaktion von Aluminium mit Silicium während der Halbleiterherstellungsverfahren auftreten. Außerdem kann die nachteilige Veränderung der Charakteristik von Schottky-Sperrschicht-Dioden währen des Halbleiterherstellungsverfahrens vermieden werden.

Das erfindungsgemäße Ätzmittel enthält beispielsweise eine Lösung von Fluorwasserstoff in Wasser, Rest Glycerin. Die Lösung enthält kein ungebundenes Wasser. Eine spezielle Zusammensetzung enthält 2 % Fluorwasserstoffsäure mit einem Gehalt an 52 Gew.% Wasser, eine kleine Menge eines Netzmittels und Rest Glycerin.

Die Erfindung wird anhand der speziellen Beschreibung und der Fign. 1 und 2A bis 2C näher erläutert.

Fig. 1 ist ein Querschnitt durch ein Silicium-Halbleitersubstrat mit dotierten Gebieten und Metallschichten, welche auf dem Siliciumsubstrat angeordnet sind und einen Transistor ergeben.

Die Fign. 2A bis 2C sind Querschnitte dieses Transistors und zeigen einen Teil des Transistors, in dem ein Fehlstellenmechanismus stattfindet, der durch die erfindungsgemäße Ätzlösung eliminiert wird.

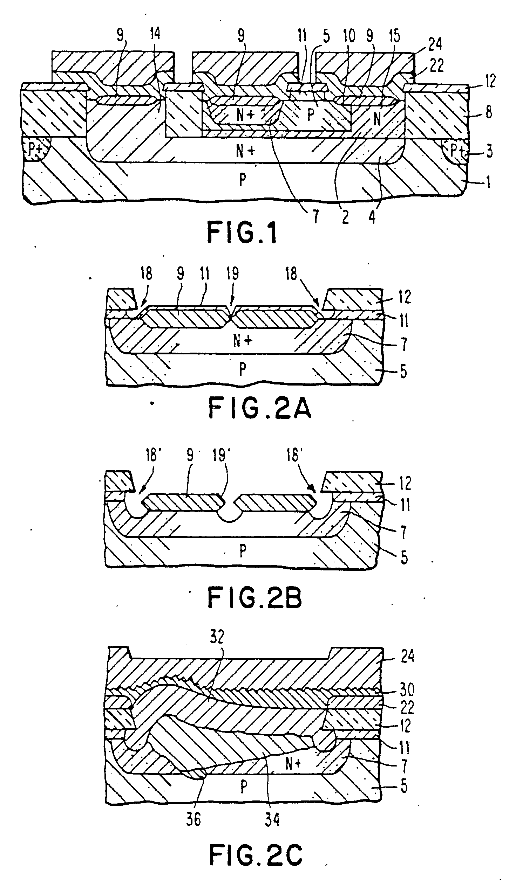

Fig. 1 zeigt einen typischen NPN-Transistor, auf den das erfindungsgemäße Verfahren angewendet wird. Der Transistor wird in konventioneller Weise hergestellt, mit der Ausnahme, daß bei seiner Herstellung die erfindungsgemäße Ätzlösung angewendet wird. Eine Beschreibung seiner Herstellung ist wesentlich für das bessere Verständnis der Erfindung. Der Transistor umfaßt ein Substrat 1 vom P-Typ, auf dem eine N-Epitaxieschicht 2 angeordnet ist. Während der Herstellung des Transistors fand eine Ausdiffusion aus dem Subkollektorbereich 4 in die Epitaxieschicht 2 statt. Der P-dotierte Bereich 3 und die dielektrischen Isolationsbereiche 8 dienen als Isolationsbereiche. Die Schicht 2 hat vorzugsweise eine Schichtdicke von etwa 2 μm oder weniger und eine Konzentration an Fremdatomen von 2,1 bis 2,3 × $10^{16}$/cm³. Dor Transistor umfaßt auch eine Basis 5 vom P-Typ, in der ein Emitterbereich 7 vom NTyp gebildet wirde. Ein Subkollektoranschluß-Bereich 14 wurde gebildet, zur Verbindung des Subkollektorbereichs 4 mit den Oberflächenkontakten.

Die Kontakte zu den dotierten Bereichen innerhalb des Halbleiterbauelements bestehen vorzugsweise aus dem Platinsilicidbereich 9, der Chromsperrschicht 22 und der Aluminium-Kupfer-Schicht 24. Durch die Metallisierung wird der Ohmsche Kontakt zu der Basis, dem Emitter und den Kollektorbereichen hergestellt, außerdem schließt die Metallisierung auch einen Schottky-Dioden-Kontakt zu der Schicht 2 im Bereich 15 ein. Demzufolge ist eine Metall-Halbleiter (Schottky)-Diode an der Oberfläche des Halbleiters vorgesehen durch die Metallisierung, welche die Bereiche 10 und 15 umschließt.

Zur Herstellung der Kontakte wird zuerst die Platinschicht 9 als Deckschicht auf dem Substrat und auf den freigelegten dotierten Bereichen angeordnet. Die nicht freigelegten Bereiche sind in üblicher Weise durch die Siliciumdioxidschicht 11 und die Siliciumnitridschicht 12 geschützt.

Das Platin wird in typischer Weise in einer Schichtdicke von etwa 40 nm durch Verdampfen oder Sputtern aufgetragen. Der Halbleiterwafer wird dann 20 Minuten bei einer Temperatur von etwa 550 °C in einer Stickstoffatmosphäre gesintert, wobei eine Reaktion des Platins mit dem Silicium unter Ausbildung von Platinsilicid 9 stattfindet. Das nicht umgesetzte Platin wird dann durch Ätzen in Königswasser entfernt. Das Platinsilicid wird während des Prozesses durch eine sehr dünne Schicht geschützt, welche Siliciumdioxid enthält. Diese Schicht wird in den folgenden Abschnitten dieser Beschreibung noch näher diskutiert. Wie bekannt ist, können auch andere Metalle wie Palladium, Nickel oder Hafnium Platin bei der Ausbildung der Metallsilicidschicht ersetzen.

Im nächsten Schritt des Verfahrens werden die Chromschicht 22 und die Schicht 24 aus Aluminium oder mit Kupfer dotiertem Aluminium oder aus mit Kupfer dotiertem Aluminium-Silicium vorzugsweise innerhalb der gleichen Aufdampfvorrichtung abgeschieden. Das Chrom wird zu einer bevorzugten Schichtdicke zwischen etwa 60 und etwa 100 nm aufgetragen. Wasserdampf wird während der Aufdampfung in die Kammer eingeleitet, so daß anstelle reinen Chroms eine Mischung aus Chrom und Chromtrioxid ($Cr_2O_3$) gebildet wird. Das Aluminium, das auch mit Kupfer dotiertes Aluminium, wie auch mit Kupfer dotiertes Aluminium-Silicium umfaßt, wird in vorteilhafter Weise in einer Schichtdicke von etwa 850 bis 1 000 nm aufgetragen. Die resultierende Schichtstruktur, die hierbei erhalten wird, ist in Fig. 1 dargestellt. In einem typischen Verfahren zur Herstellung integrierter Schaltkreise werden mindestens noch eine Metallisierungsebene und möglicherweise zwei ausgebildet, um die vielen hundert Schaltkreise, die sich auf dem gleichen Halbleiterchip befinden, untereinander zu verbinden.

Die Abscheidung der Metallisierung, welche die Chromschicht 22 und die Aluminiumschicht 24 umfaßt, wird in vorteilhafter Weise unter Anwendung eines Verfahrens durchgeführt, welches in der US-Patentschrift 4 004 044 beschrieben ist. Andere Technologien zur Ausbildung der Metallisierung sind die üblichen substraktiven Ätzverfahren unter Anwendung von Naßätzen oder reaktiven Ionenätzens, die dem Fachmann gut bekannt sind. Mit der Lift-Off-Technologie jedoch wird eine wesentlich verbesserte Definition der Metallisierung erhalten, wodurch der Bereich, der zur Verdrahtung erforderlich ist, herabgesetzt wird. Die beschriebenen Verfahren zur Ausbildung der Metallisierung sind nicht Gegenstand der Erfindung. In der Tat ist die Erfindung in keiner Weise von der Zusammensetzung der Metallschichten 22 und 24 abhängig. Es können dagegen auch andere Metallisierungssysteme, die dem Fachmann in der Halbleiterindustrie bekannt sind, verwendet werden.

Der Fehlermechanismus, auf den zuvor hingewiesen wurde, ist anhand des Emitterbereichs des Transistors in den Fign. 2A bis 2C dargestellt. Dargestellt ist der Zustand, nach dem das überschüssige Platin durch das Ätzmittel Königswasser entfernt wurde und das Platinsilicid (PtSi) zum Schutz mit einer dünnen, etwa 3 nm dicken Siliciumdioxidschicht 11 bedeckt ist. Wie zuvor angedeutet, kann das Königswasser auch bestimmte, örtlich festgelegte Bereiche des Platinsilicids angreifen unter Freilegung von Silicium. Im vorliegenden Beispiel sind die Bereiche 18 unter der Unterschneidung der Siliciumnitridschicht 12 dem Ätzmittel ausgesetzt, und ein Teil der Platinsilicidschicht 9 seinerseits weist eine Öffnung im Bereich 19 auf.

Die genaue chemische Zusammensetzung der Schicht 11 ist nicht bekannt, weil eine Analyse einer 3 nm dicken Schicht sehr schwierig ist. Sie besteht mit höchster Wahrscheinlichkeit aus Siliciumdioxid, obgleich ihre Zusammensetzung auch komplexer sein kann.

Bei dem nächsten Schritt des Herstellungsverfahrens wird die dünne Siliciumdioxidschicht 11 von der Oberfläche des Platinsilicids entfernt, damit ersteres nicht als die Komponente der Kontaktmetallurgie, welche einen hohen Widerstand aufweist, wirkt. Üblicherweise wird die Siliciumdioxidschicht 11 unter Anwendung gepufferter Flußsäurelösung entfernt. Eine typische Mischung wird hergestellt aus 15 Teilen $NH_4$-F-Lösung, welche etwa 60 % Wasser enthält und einem Teil Flußsäurelösung und vier Teilen Wasser.

Wie aus Fig. 2B ersichtlich ist, kann jedoch die Flußsäure das freiliegende $N^+$-Silicium angreifen. In der Praxis werden durch Standard-gepufferte Flußsäurelösung etwa 0,7 $\mu$m $N^+$-dotierten Siliciums in 50 Sekunden Ätzzeit entfernt. Soweit bekannt ist, wurde dieses Problem bisher von niemandem in der Halbleiterindustrie erkannt. Wie Versuche ergeben haben, ist die Erosion der $N^+$-Gebiete in den Bereichen 18' und 19' wahrscheinlich zurückzuführen auf eine elektrochemische Reaktion zwischen dem Silicium 7 und der Platinsilicidschicht 9. Dies wird gestützt durch die Tatsache, daß ein Potential von ungefähr 0,25 Volt zwischen dem Platinsilicid und einem $N^+$-Siliciumbereich gemessen wird, wenn diese in gepufferte Flußsäure eingetaucht werden.

Es ist ersichtlich, daß es auch andere Möglichkeiten gibt, um diesen Zustand zu verbessern. Beispielsweise würde eine verbesserte Abdeckung mit Platin, welche kein Silicium unbedeckt läßt, diese Situation erheblich mildern. Es ist jedoch sehr schwierig, Platin, welches eines Schichtdicke von nur etwa 40 nm aufweist, so aufzudampfen, daß eine vollständige Bedeckung gewährleistet ist.

Im nächsten Schritt des Verfahrens, das anhand von Fig. 1 beschrieben wird, werden die Schichten 22 aus Chrom und 24 aus mit Kupfer dotiertem Aluminium abgeschieden. Wegen der Vertiefungen 18' und 19' in dem Silicium sind die abgeschiedenen Schichten nicht einheitlich. Tatsächlich findet eine Wechselwirkung statt, so daß sehr wenig von der abgeschiedenen Metallurgie erhalten bleibt. Dies trifft insbesondere zu, nachdem die Metallurgie in üblicher Weise bei etwa 450 °C gesintert wurde. Unter Anwendung der Photomikrographie konnte festgestellt werden, daß verschiedene intermetallische Verbindungen gebildet werden. Unter diesen sind eine Chromsilicium-Schicht 30, eine Chromaluminium-Schicht 32, ein $PtAl_2$-Schicht 34, wie auch eine Aluminium-Kupfer-Silicium-Schicht 36. Die Existenz der Schicht 36 weist auf ein schwerwiegendes Problem hin, weil sie anzeigt, daß das Aluminium-Kupfer 24 durch das Silicium hindurch zum Basis-Emitter-Übergang selbst vorgedrungen ist. Diese Vorrichtung ist nicht mehr funktionsfähig.

Ein analoges Problem existiert im Hinblick auf die Schottky-Sperrschicht 15 (Fig. 1) obgleich das Problem in der Zeichnung nicht dargestellt ist. Wie zuvor diskutiert, bewirkt ein direkter Kontakt zwischen der Aluminiumschicht 24 und dem Silicium 2 eine Spannungscharakteristik, welche wesentlich von der geplanten abweicht.

Es wurde gefunden, daß durch die Eliminierung allen oder fast allen ungebundenen Wassers aus der Flußsäurelösung und dessen Ersatz durch ein organisches Lösungsmittel, vorzugsweise Glycerin, dieses Problem gelöst werden kann. In der Praxis ist es schwierig, irgendeine Flußsäurelösung zu erhalten, welche kein Wasser enthält. Die im Handel erhältliche Flußsäure enthält 52 Gew.% Wasser, die restlichen 48 % sind HF. Wenn sie jedoch mit Glycerin gemischt wird, enthält die Mischung kein ungebundenes Wasser mehr, d. h. es sind keine Wassermoleküle in ungebundenem Zustand vorhanden, weil sie am Glycerin oder an andere mehrwertige Alkohole gebunden sind.

Der bevorzugte Bereich der Mischung enthält etwa 1 bis 4 % HF, die ihrerseits aus 52 % Wasser und 48 % HF besteht, und der Rest ist Glycerin. Diese Prozentgehalte stellen keine absoluten Grenzen dar. Tatsächlich sind Mengen bis zu 20 % HF wirksam, aber eine Kontrolle des Ätzprozesses, insbesondere in der Produktionslinie, wird dadurch sehr erschwert. Eine Mischung mit einem Gehalt an 2 % HF scheint am günstigsten zu sein.

Zu der Mischung I kann auch ein neutrales oder anionisches Netzmittel in einer Menge von 0 bis 5 Gew.% zugefügt werden.

Als solches ist beispielsweise ein Netzmittel auf der Basis von Äthylendiamintetraessigsäure und deren Na-, $NH_4$- oder Na-Ca-Salze oder Nitrilotriessigsäure-Natriumsalz, das unter dem Handelsnamen Versen von Dow erhältlich ist, brauchbar. Es ist entscheidend, daß im wesentlichen kein $NH_4F$ in der Lösung vorhanden ist, weil dieses dazu neigt, die Lochbildung in der Platinsilicidschicht zu bewirken.

Außer Glycerin können auch andere organische Lösungsmittel wie Äthylenglykol, Propylenglykol und anderen Glieder der mehrwertigen Alkohole mit Erfolg verwendet werden. Wenn das erfindungsgemäße neue Ätzmittel verwendet wird, treten die ausgedehnten Vertiefungen 18' und 19', die in Fig. 2 dargestellt sind, nicht auf. Darüber hinaus werden Änderungen der Charakteristik von Schottky-Dioden, welche durch den Kontakt von Aluminium mit Silicium verursacht werden, eliminiert. Die Dauer der Ätzung liegt bei etwa 5 Sekunden, obgleich größere Ätzzeiten als diese keine weitere Ausbildung von Vertiefungen bewirken.

### Patentansprüche

1. Ätzmittel zum Ätzen von Siliciumoxiden mit einem Gehalt an Fluorwasserstoff und einer alles ungebundene Wasser absorbierenden organischen Verbindung, dadurch gekennzeichnet, daß das Ätzmittel kein Ammoniumfluorid zur Pufferung enthält.

2. Ätzmittel nach Anspruch 1, dadurch gekennzeichnet, daß es als organische Verbindung einen mehrwertigen Alkohol aus der Gruppe von Glycerin, Äthylenglykol, Propylenglykol enthält.

3. Ätzmittel nach den Ansprüchen 1 und 2, gekennzeichnet durch einen Gehalt an Glycerin.

4. Ätzmittel nach Anspruch 1, gekennzeichnet durch einen Gehalt an 1 bis 4 % einer Lösung von Fluorwasserstoff in Wasser und Rest Glycerin.

5. Ätzmittel nach den Ansprüchen 1 und 4, gekennzeichnet durch einen Gehalt an 2 % einer Lösung von Fluorwasserstoff in Wasser und Rest Glycerin.

6. Ätzmittel nach den Ansprüchen 1, 4 und 5, gekennzeichnet durch einen Gehalt an einer 48 %-igen Lösung von Fluorwasserstoff in Wasser.

7. Ätzmittel nach den Ansprüchen 1 bis 6, dadurch gekennzeichnet, daß es zusätzlich ein Netzmittel enthält.

8. Verfahren zum Ätzen von Siliciumoxid, das auf einer Metallschicht, unter der oder in der Umgebung derselben Silicium freigelegt ist, angeordnet ist, dadurch gekennzeichnet, daß ein Ätzmittel gemäß den Ansprüchen 1 bis 7 angewendet wird, das eine Lösung von Fluorwasserstoff in Wasser, Glycerin und gegebenenfalls ein Netzmittel, aber kein ungebundenes Wasser und kein Ammoniumfluorid enthält.

9. Verfahren nach Anspruch 8, dadurch gekennzeichnet, daß das Ätzmittel auf freigelegtes Silicium mit einer N⁺- oder N-Dotierung einwirkt.

10. Verfahren nach den Ansprüchen 8 und 9, dadurch gekennzeichnet, daß Siliciumoxid, das auf einer Platinsilicidschicht angeordnet ist, geätzt wird.

### Claims

1. Etchant for etching silicon oxides containing hydrogen fluoride and an organic compound absorbing all unbound water, characterized in that the etchant does not contain any ammoniumfluoride for buffering.

2. Etchant as claimed in claim 1, characterized in that as an organic compound it comprises a multivalent alcohol selected from the group comprising glycerol, ethylene glycol, propylene glycol.

3. Etchant as claimed in any one of claims 1 and 2, characterized in that it comprises glycerol.

4. Etchant as claimed in claim 1, characterized in that it contains 1 to 4 % of a solution of hydrogen fluoride in water and remainder glycerol.

5. Etchant as claimed in any one of claims 1 and 4, characterized in that it contains 2 % of a solution of hydrogen fluoride in water and remainder glycerol.

6. Etchant as claimed in any one of claims 1, 4 and 5, characterized in that it contains a 48 % solution of hydrogen fluoride in water.

7. Etchant as claimed in any one of claims 1 to 6, characterized in that it additionally contains a wetting agent.

8. Method for etching silicon oxide arranged on a metal layer under which or near which silicon has been exposed, characterized in that an etchant as disclosed by claims 1 to 7 is used which comprises a solution of hydrogen fluoride in water, glycerol and, if necessary, a wetting agent but no unbound water and no ammoniumfluoride.

9. Method as claimed in claim 8, characterized in that the etchant acts on exposed silicon with an N⁺ or N doping.

10. Method as claimed in any one of claims 8 and 9, characterized in that silicon oxide arranged on a platinum silicide layer is etched.

### Revendications

1. Produit pour l'attaque des oxydes de silicium, contenant du fluorure d'hydrogène ou un composé organique absorbant toute l'eau non combinée, caractérisé en ce que le produit d'attaque ne contient pas de fluorure d'ammonium pour le tamponnage.

2. Produit selon la revendication 1, caractérisé en ce qu'il contient en tant que composé organique un alcool polyvalent du groupe du glycérol, de l'éthylène-glycol, du propylène-glycol.

3. Produit selon les revendications 1 et 2, caractérisé en ce qu'il contient du glycérol.

4. Produit selon la revendication 1, caractérisé en ce qu'il contient de 1 à 4 % d'une solution de fluorure d'hydrogène dans l'eau, le solde consistant en glycérol.

5. Produit selon les revendications 1 et 4, caractérisé en ce qu'il contient 2 % d'une solution de flurorure d'hydrogène dans l'eau, le solde consistant en glycérol.

6. Produit selon les revendications 1, 4 et 5, caractérisé en ce qu'il contient une solution de fluorure d'hydrogène à 48 % dans l'eau.

7. Produit selon les revendications 1 à 6, caractérisé en ce qu'il contient en outre un agent mouillant.

8. Procédé pour l'attaque de l'oxyde de silicium appliqué sur une couche métallique sous laquelle ou dans l'environnement de laquelle il y a libération de silicium, caractérisé en ce que l'on utilise un produit d'attaque selon les revendications 1 à 7, contenant une solution de fluorure d'hydrogène dans l'eau, du glycérol et le cas échéant un agent mouillant, mais pas d'eau non combinée et pas de fluorure d'ammonium.

9. Procédé selon la revendication 8, caractérisé en ce que le produit d'attaque agit sur le silicium contenant une addition de $N^+$ ou de N, libéré.

10. Procédé selon les revendications 8 et 9, caractérisé en ce que l'on attaque un oxyde de silicium appliqué sur une couche de siliciure de platine.

FIG.1

FIG.2A

FIG.2B

FIG.2C